# EUROPEAN PATENT APPLICATION

(11) **EP 4 739 055 A1**
(43) Date of publication of application: **06.05.2026**
(21) Application number: 25212654.5
(22) Date of filing: 31.10.2025
(51) Int. Cl.: H10K 59/131, H10K 59/40

(54) **DISPLAY DEVICE INCLUDING PANEL PADS IN A NON-DISPLAY REGION AND ELECTRONIC DEVICE INCLUDING THE SAME**

(30) Priority: 01.11.2024 KR 20240153599
(71) Applicant: Samsung Display Co., Ltd., Yongin-si, Gyeonggi-do 17113 (KR)
(72) Inventor: LEE, Seeook, 17113 Yongin-si (KR); KANG, Eui Jeong, 17113 Yongin-si (KR); KO, Hyunseok, 17113 Yongin-si (KR); LEE, Dong-Youb, 17113 Yongin-si (KR); WON, Changwoo, 17113 Yongin-si (KR); HWANG, Jinuk, 17113 Yongin-si (KR)
(74) Representative: Walaski, Jan Filip

(57) **Abstract**

A display device includes a substrate having a display area and a non-display area proximate to the display area. A thin-film transistor is disposed on the substrate. A light-emitting element is disposed within the display area on the substrate and is electrically connected to the thin-film transistor. The non-display area includes a pad area in which a plurality of panel pads arranged in a first direction are disposed. A first panel pad group and a second panel pad group are arranged in the first direction are disposed in the pad area. The first panel pad group includes first panel pads having a first predetermined distance between adjacent first panel pads. The second panel pad group includes second panel pads having a second predetermined distance between adjacent second panel pads. The first predetermined distance is different from the second predetermined distance.

## Description

### CROSS-REFERENCE TO RELATED APPLICATION

This application claims priority to Korean Patent Application No. 10-2024-0153599, filed on 1 November 2024 in the Korean Intellectual Property Office.

### TECHNICAL FIELD

The present disclosure relates to a display device and, more specifically, to a display device including panel pads in a non-display region and an electronic device including the same.

### DISCUSSION OF THE RELATED ART

Typically, a display device consists of multiple electronic components. For example, electronic devices such as mobile phones, laptop computers, and televisions contain an electro-optical panel that generates images, along with a main circuit board and connection circuit boards that facilitate signal transmissions.

The connection circuit board may be electrically connected to the display panel, transmitting the necessary signals for display operation. To establish this connection, pads on both the connection circuit board and the display panel are bonded together.

As display regions have expanded in modem devices, the available space for the connection circuit board has decreased. Consequently, reducing the size of the connection circuit board has become necessary to accommodate this change while maintaining functionality.

### SUMMARY

A display device includes a substrate having a display area and a non-display area proximate to the display area. A thin-film transistor is disposed on the substrate. A light-emitting element is disposed within the display area on the substrate and is electrically connected to the thin-film transistor. The non-display area includes a pad area in which a plurality of panel pads arranged in a first direction are disposed. A first panel pad group and a second panel pad group are arranged in the first direction are disposed in the pad area. The first panel pad group includes first panel pads having a first predetermined distance between adjacent first panel pads. The second panel pad group includes second panel pads having a second predetermined distance between adjacent second panel pads. The first predetermined distance is different from the second predetermined distance.

A third panel pad group including third panel pads arranged in the first direction and having a third predetermined distance between adjacent third panel pads may be further disposed in the pad area. The third predetermined distance may be different from each of the first predetermined distance and the second predetermined distance.

The first panel pad group, the second panel pad group, and the third panel pad group may be sequentially arranged in the first direction in the pad area.

The first predetermined distance and the third predetermined distance may each be less than the second predetermined distance.

The first panel pad group and/or the third panel pad group may be electrically connected to a touch line.

At least two panel pads among the first panel pads and the second panel pads may be inclined without being parallel to each other.

Upper ends of the panel pads in a second direction perpendicular to the first direction may be disposed colinearly in the first direction.

A first width, which is a width of the first panel pad, may be different from a second width, which is a width of the second panel pad.

The display device may further include a connection circuit board having a plurality of connection pads arranged in the first direction. A first connection pad group and a second connection pad group may be arranged in the first direction and may be disposed on the connection circuit board. The first connection pad group may include first connection pads having a fourth predetermined distance between adjacent first connection pads. The second connection pad group may include second connection pads having a fifth predetermined distance between adjacent second connection pads. Each of the first connection pads may overlap and may be electrically connected to a corresponding one of the first panel pads in at least a region and each of the second connection pads may overlap and may be electrically connected to a corresponding one of the second panel pads in at least a region.

The fourth predetermined distance may be different from the fifth predetermined distance.

A display device includes a substrate having a display area and a non-display area proximate to the display area. A thin-film transistor is disposed on the substrate. A light-emitting element is disposed within the display area on the substrate and is electrically connected to the thin-film transistor. The non-display area includes a pad area in which a plurality of panel pads arranged in a first direction are disposed. A first panel pad group and a second panel pad group arranged in the first direction are disposed in the pad area. The first panel pad group includes first panel pads having a first predetermined width with respect to each other. The second panel pad group includes second panel pads having a second predetermined width with respect to each other.

The first predetermined width is different from the second predetermined width.

A third panel pad group including third panel pads arranged in the first direction and having a third predetermined width with respect to each other may be further disposed in the pad area. The third predetermined width may be different from each of the first predetermined width and the second predetermined width.

The first panel pad group, the second panel pad group, and the third panel pad group may be sequentially arranged in the first direction in the pad area.

The first predetermined width and the third predetermined width may each be less than the second predetermined width.

A first distance, which is the distance between the first panel pads, may be different from a second distance, which is the distance between the second panel pads.

At least two panel pads among the first panel pads and the second panel pads may be inclined without being parallel to each other.

Each of the first panel pad group and the second panel pad group may have a width in the first direction. First ends of the first panel pad group and the second panel pad group, which are closest to the display area, may have a narrower width than second ends of the first panel pad group and the second panel pad group, which are closest to an edge of the substrate. Opposite terminals of the panel pads in a second direction perpendicular to the first direction may be disposed colinearly in the first direction.

A connection circuit board having a plurality of connection pads arranged in the first direction may further be included. A first connection pad group and a second connection pad group arranged in the first direction may be disposed on the connection circuit board. The first connection pad group may include first connection pads having a fourth predetermined distance between adjacent first connection pads. The second connection pad group may include second connection pads having a fifth predetermined distance between adjacent second connection pads. The first connection pad may be electrically connected to the first panel pad group, and the second connection pads may be electrically connected to the second panel pad group.

The fourth predetermined distance may be different from the fifth predetermined distance.

An electronic device includes a controller configured to generate a scan input signal, a power module configured to generate a scan input voltage, a display panel divided into a display area in which a pixel circuit is disposed and a non-display area proximate to the display area, and a scan driver disposed in the non-display area and configured to receive the scan input signal and the scan input voltage and output a scan signal to the pixel circuit. The non-display area includes a pad area in which a plurality of panel pads arranged in a first direction are disposed. A first panel pad group and a second panel pad group arranged in the first direction are disposed in the pad area. The first panel pad group includes first panel pads having a first predetermined distance between adjacent first panel pads. The second panel pad group includes second panel pads having a second predetermined distance between adjacent second panel pads. The first predetermined distance is different from the second predetermined distance.

### BRIEF DESCRIPTION OF THE DRAWINGS

A more complete appreciation of the present disclosure and many of the attendant aspects thereof will be readily obtained as the same becomes better understood by reference to the following detailed description when considered in connection with the accompanying drawings, wherein:
FIG. 1 is a plan view schematically showing a display device according to an embodiment;
FIG. 2 is a cross-sectional view schematically showing an example of a cross-section taken along line I-I' of FIG. 1;
FIG. 3 is a cross-sectional view schematically showing an example of a cross-section taken along line I-I' of FIG. 1;
FIG. 4 is a plan view schematically showing a pad region of FIG. 1 according to an embodiment;
FIG. 5 is a plan view schematically showing a pad region of FIG. 1 according to an embodiment;
FIG. 6 is a plan view schematically showing a part of a display device separated from a portion A of FIG. 1;
FIG. 7 is a plan view schematically showing a display device in a portion A of FIG. 1;
FIG. 8 is a cross-sectional view schematically showing a cross-section taken along line II-II' of FIG. 1;
FIG. 9 is a cross-sectional view schematically showing a cross-section taken along line III-III' of FIG. 1;
FIG. 10 is a block diagram of an electronic device according to embodiments of the present disclosure;
FIG. 11 is a perspective view describing an electronic device to which a display device according to an embodiment is applied;
FIGS. 12 is a perspective view and FIG. 13 is a schematic diagram illustrating an electronic device to which a display device according to an embodiment is applied; and
FIG. 14 is a perspective view illustrating an electronic device to which a display device according to an embodiment is applied.

### DETAILED DESCRIPTION

The present disclosure may have various modifications thereto and various embodiments, and thus particular embodiments will be illustrated in the drawings and described in detail in a detailed description. Effects and features of the present disclosure, and methods for achieving them will become clear with reference to the embodiments described later in detail together with the drawings. However, the present disclosure is not necessarily limited to the embodiments disclosed below and may be implemented in various forms.

In the following embodiments, singular forms include plural forms unless apparently indicated otherwise contextually.

In the following embodiments, the terms "include," "have," or the like, are intended to mean that there are features, or components, described herein, but do not preclude the possibility of adding one or more other features or components.

In the following embodiments, when a portion, such as a film, a region, a component, etc., is present on or above another portion, this case may include not only a case where it is directly on the other portion, but also a case where another film, region, component, etc., is arranged between the portion and the other portion.

In the examples below, terms such as connect or combine do not necessarily imply a direct and/or fixed connection or combination of two members, unless the context clearly indicates otherwise, and do not exclude the presence of another member between the two members.

While each drawing may represent one or more particular embodiments of the present disclosure, drawn to scale, such that the relative lengths, thicknesses, and angles can be inferred therefrom, it is to be understood that the present invention is not necessarily limited to the relative lengths, thicknesses, and angles shown. Changes to these values may be made within the spirit and scope of the present disclosure, for example, to allow for manufacturing limitations and the like.

Hereinafter, embodiments of the present disclosure will be described in detail with reference to the attached drawings. To the extent that an element is not described in detail with respect to this figure, it may be understood that the element is at least similar to a corresponding element that has been described elsewhere within the present disclosure.

Exemplary embodiments of the present disclosure relate to optimization of a pad layout in a display device to improve design flexibility and reduce the area required for connection circuits. This innovation enables narrower bezels, cost reduction, and better structural design in electronic devices such as smartphones, laptops, and televisions.

The display device may feature a pad area with multiple panel pad groups, where the spacing and width of the panel pads vary. Different distances (pitch) between panel pads allow for a more efficient use of space. The layout may enable a reduction in the connection circuit board size, optimizing the non-display area. By adjusting the pitch and width of the panel pads, the required space for the connection circuit board may be minimized. This reduction may allow for a thinner and more compact display, leading to cost savings in materials.

Different groups of panel pads may be allocated based on function, such as power lines, which require lower resistance and thus wider pads, and touch sensor lines, which can tolerate higher resistance and thus use smaller, more closely packed pads. This selective approach may enhance efficiency without compromising performance.

Some panel pads may be disposed at an inclination, rather than being strictly parallel. This may improve electrical connections and manufacturing tolerances, ensuring better alignment with the connection circuit board.

The connection circuit board may contain corresponding connection pads with spacing and widths matched to the panel pads. This means of connection may ensure optimal signal transmission and mechanical stability.

According to this arrangement, many practical benefit may be achieved. For example, narrower bezels may be achieved by reducing the non-display area. Cost savings may be achieved by requiring a smaller connection circuit board. Better integration of touch sensors and display drivers in high-resolution displays may be achieved.

Moreover, these structural improvements may enhance durability and manufacturing efficiency.

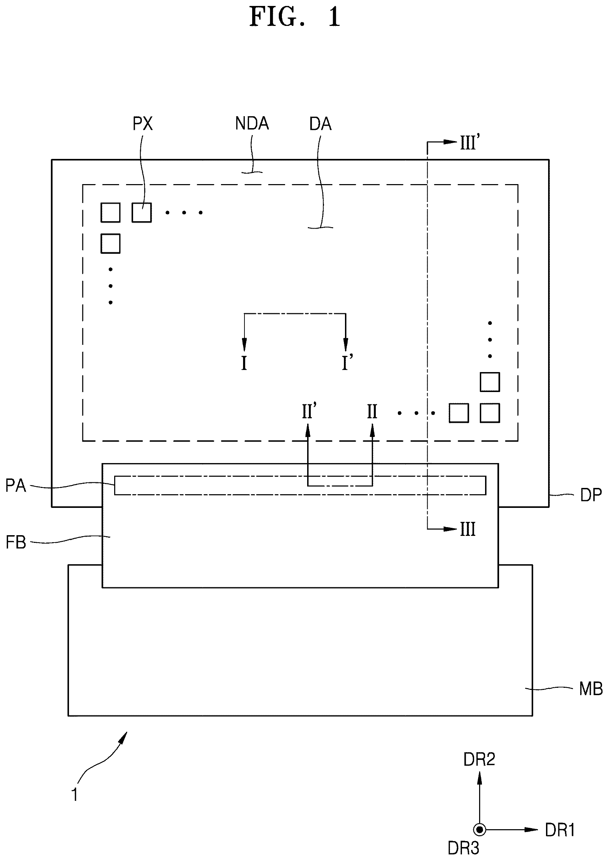

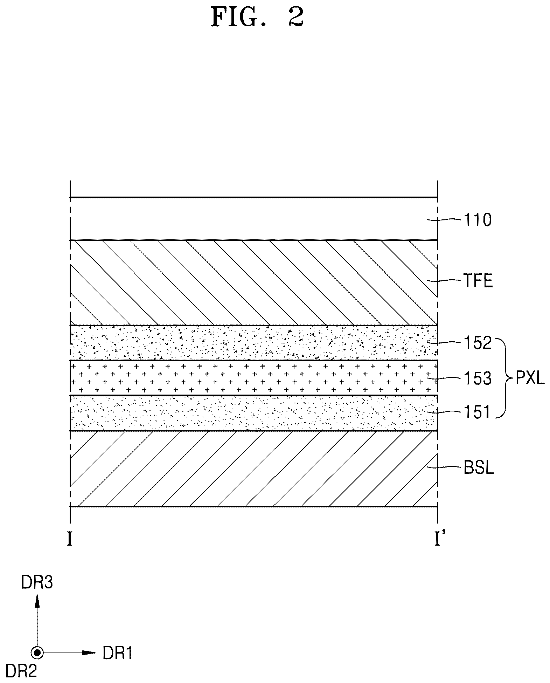

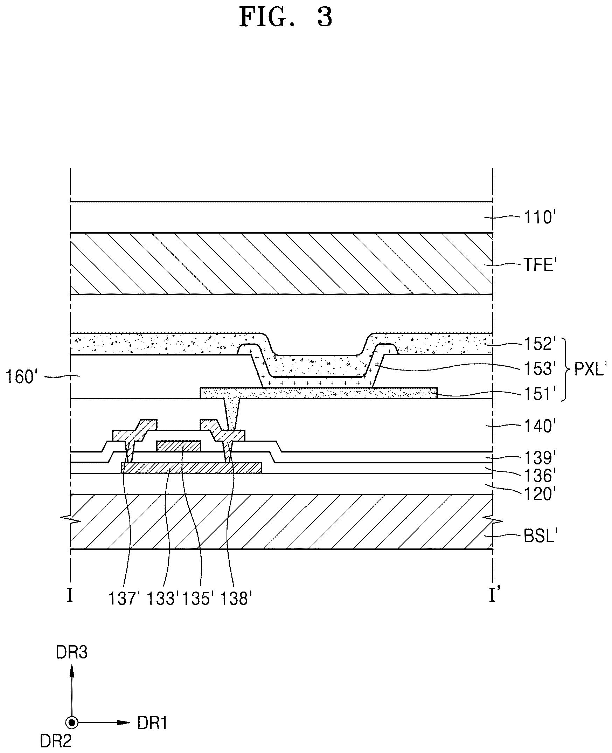

FIG. 1 is a plan view schematically showing a display device according to an embodiment, FIG. 2 is a cross-sectional view schematically showing an example of a cross-section taken along line I-I' of FIG. 1, and FIG. 3 is a cross-sectional view schematically showing another example of a cross-section taken along line I-I' of FIG. 1.

Referring to FIG. 1, a display device 1 may include a display panel DP. As a selective embodiment, the display device 1 may further include a connection circuit board FB or a main circuit board MB. The display panel DP, the connection circuit board FB, and the main circuit board MB may be electrically connected to one another.

The display panel DP may include a display area DA and a non-display area NDA. In some embodiments, a substrate BSL of the display panel DP may include the display area DA and the non-display area NDA proximate to the display area DA. The display area DA is a portion where an image is displayed, and the non-display area NDA surrounding the display area DA may be a portion where circuits and/or signal lines for generating and/or transmitting various signals to be applied to the display area DA are disposed. No image is displayed within the non-display area NDA.

The non-display area NDA may include a pad area PA in which a plurality of panel pads PP are disposed in a first direction DR1. Panel pad groups disposed in the first direction DR1 may be disposed in the pad area PA. The display panel DP may be connected to the connection circuit board FB in the pad area PA.

A plurality of pixels PX that receive signals from signal lines may be disposed in the display area DA of the display panel DP. In an embodiment, each of the pixels PX may receive an electrical signal and display light constituting an image. The pixels PX may be arranged in a matrix shape, spaced apart from each other in the first direction DR1 and a second direction DR2. The display panel DP may display various images by controlling the pixels PX. However, FIG. 1 is an example, and some components of the pixels PX may overlap each other on a plane, and are not necessarily limited to any one embodiment.

Each pixel PX may include a display element and a driving element. The display element may include various embodiments. For example, the display element may be at least any one of a liquid crystal capacitor, a light-emitting element, an electrophoretic element, and an electrowetting element. However, this is described as an example, and the display element may include various embodiments as long as it may implement an image according to an electrical signal, and the display element is not necessarily limited to any one embodiment.

The driving element may control the driving of each display element of each pixel PX. The driving element may include a thin-film transistor. The display panel DP may be driven by an active method in which each pixel PX may be independently controlled.

Signal lines such as scan lines, data lines, driving voltage lines, common voltage lines, and/or initialization voltage lines may be disposed in the display area DA. Each pixel PX may be connected to a scan line, a data line, a driving voltage line, a common voltage line, and/or an initialization voltage line, and may receive a scan signal, a data voltage, a driving voltage, a common voltage, and/or a driving voltage from the signal lines. The pixel PX may include a light-emitting element such as a light-emitting diode. Touch electrodes may be disposed in the display area DA of the display panel DP to detect touch from a user's finger, etc.

Referring to FIG. 2, which schematically shows a cross-section of a portion of the display area DA of the display panel DP, the display panel DP may have a pixel layer PXL capable of generating visible light so as to provide visible light to a user. The type of the pixel PX included in the pixel layer PXL may vary, and the current embodiment describes a case where the pixel PX is an organic light-emitting diode (OLED) element.

The display panel DP will be described in detail. The display panel DP may include the pixel layer PXL on the substrate BSL. As a selective embodiment, the display panel DP may further include an encapsulation layer TFE and a photo-functional layer 110.

The substrate BSL may be formed using various materials. As a specific example, the substrate BSL may include glass, metal, or other organic materials.

As a selective embodiment, the substrate BSL may include a flexible material. For example, the substrate BSL may be flexible, bendable, foldable, or rollable.

For example, the substrate BSL may contain ultra-thin glass, metal or plastic-based materials, for example, polyimide (PI) when using plastic, and as another specific example, the substrate BSL may contain at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polycarbonate, triacetate cellulose, and cellulose acetate propionate.

The pixel layer PXL may be formed on the substrate BSL and may include a first electrode 151, a second electrode 152, and an intermediate layer 153. In some embodiments, the first electrode 151 may be formed on the substrate BSL, the second electrode 152 may be formed on the first electrode 151, and the intermediate layer 153 may be formed between the first electrode 151 and the second electrode 152.

A buffer layer may be further formed on the first electrode 151 and the substrate BSL. The buffer layer may provide a flat surface on the substrate BSL and may block moisture or gas infiltrating through the substrate BSL.

The first electrode 151 may function as an anode, and the second electrode 152 may function as a cathode, but such an order of polarities may be reversed. When the first electrode 151 functions as an anode, the first electrode 151 may include ITO, IZO, ZnO, In₂O₃, etc., having a high work function. Depending on the purpose and design conditions, the first electrode 151 may further include a reflective film including Ag, Mg, Al, Pt, Pd, Au, Ni, Nd, Ir, Cr, Li, Yb, Ca, etc.

When the second electrode 152 functions as a cathode, the second electrode 152 may include a metal such as Ag, Mg, Al, Pt, Pd, Au, Ni, Nd, Ir, Cr, Li, Ca, etc. The second electrode 152 may include ITO, IZO, ZnO, In₂O₃, etc., to enable light transmission.

The intermediate layer 153 may include at least an organic light-emitting layer. The intermediate layer 153 may selectively include at least one of a hole injection layer, a hole transport layer, an electron transport layer, and an electron injection layer in addition to an organic light-emitting layer. When voltage is applied to the first electrode 151 and the second electrode 152, visible light may be generated from the intermediate layer 153, particularly, from the organic light-emitting layer of the intermediate layer 153.

The encapsulation layer TFE may be disposed on the pixel layer PXL to protect the pixel PX. The encapsulation layer TFE may protect the pixel layer PXL from external impact and reduce or prevent the infiltration of external foreign substances or moisture, etc.

The encapsulation layer TFE may be formed as various types. In a selective embodiment, the encapsulation layer TFE may be formed of a transparent glass material having SiO₂ as a main component. In another selective embodiment, the encapsulation layer TFE may be formed of a plastic material capable of transmitting light. In another selective embodiment, the encapsulation layer TFE may be formed using an organic film or an inorganic film. In another selective embodiment, the encapsulation layer TFE may be formed by laminating one or more organic films and one or more inorganic films, and in this case, may be formed by alternately laminating the organic films and the inorganic films.

The display panel DP may provide an image in an upward direction, for example, in an upward direction with respect to the third direction, for example, toward the photo-functional layer 110. The photo-functional layer 110 may include a base material and photo-functional particles.

The display panel DP may include a thin-film transistor that transmits a signal required for driving the pixel PX to the pixel PX. A detailed description will be provided with reference to FIG. 3.

FIG. 3 shows a modified example of FIG. 2. Referring to FIG. 3, the display panel DP may include a substrate BSL', a pixel layer PXL', a thin-film transistor, and an encapsulation layer TFE'.

The thin-film transistor may include an active layer 133', a gate electrode 135', a source electrode 137', and a drain electrode 138'. A detailed description will be made. On the substrate BSL', a buffer layer 120' may be formed. The buffer layer 120' may provide a flat surface on the substrate BSL' while preventing impurity elements from penetrating the substrate BSL', and may be formed of various materials capable of playing such a role. The buffer layer 120' is an optional component and may be omitted.

The active layer 133' may be disposed in a selected pattern on the buffer layer 120'. The active layer 133' may include an inorganic semiconductor material such as silicon, may include an organic semiconductor material as a selective embodiment, and may contain an oxide semiconductor material as another selective embodiment.

The gate insulating film 136' may be formed on the active layer 133'. The gate insulating film 136' may include various insulating materials, and may be formed using, for example, an oxide or a nitride.

A gate electrode 135' may be formed on top of a gate insulating film 136' to correspond to a predetermined region of the active layer 133'. The gate electrode 135' may include a material with good conductivity. For example, the gate electrode 135' may contain Au, Ag, Cu, Ni, Pt, Pd, Al, and Mo, and may include an alloy such as an Al:Nd, Mo:W alloy, etc. However, this is just an example and the current embodiment is not necessarily limited thereto and may include various materials.

An interlayer insulating film 139' may cover the gate electrode 135'. The source electrode 137' and the drain electrode 138' may be formed on the interlayer insulating film 139'. The source electrode 137' and the drain electrode 138' may be in contact with a selected region of the active layer 133'.

A passivation layer 140' may cover the source electrode 137' and the drain electrode 138'. A separate insulating film may be formed on the passivation layer 140' to planarize the thin-film transistor.

For example, the display device 1 may include a thin-film transistor positioned on the substrate BSL' and a light-emitting element positioned in the display area DA on the substrate BSL' and electrically connected to the thin-film transistor.

The display device 1 may further include one or more thin-film transistors electrically connectable to the pixel layer PXL', and may further include one or more capacitors electrically connectable to the pixel layer PXL' or the thin-film transistor.

A first electrode 151' may be formed on the passivation layer 140'. The first electrode 151' may be electrically connected to one of the source electrode 137' and the drain electrode 138'. For example, the first electrode 151' may be connected to the drain electrode 138'.

A pixel-defining film 160' may be formed on the first electrode 151' and may expose a selected region of the first electrode 151'.

An intermediate layer 153' may be formed on the first electrode 151'. The intermediate layer 153' may have an organic light-emitting layer. As a selected embodiment, the intermediate layer 153' may further include at least one of a hole injection layer, a hole transport layer, an electron transport layer, and an electron injection layer, in addition to the organic light-emitting layer.

The second electrode 152' may be formed on the intermediate layer 153'.

The encapsulation layer TFE may be disposed on the pixel layer PXL to protect the pixel PX.

As an optional embodiment, the display panel DP may further include a photo-functional layer 110'. The photo-functional layer 110' may include a layer for improving, changing, and variously controlling characteristics of light implemented in the pixel layer PXL'.

The non-display area NDA may be adjacent to the display area DA. The non-display area NDA may be disposed on at least a side of the display area DA on the display panel DP. For example, the non-display area NDA may surround the display area DA. In FIG. 1, a boundary between the display area DA and the non-display area NDA is indicated by a dotted line. However, this is merely an example, and the non-display area NDA may have various shapes as long as it is adjacent to the display area DA, and is not necessarily limited to any one embodiment.

The non-display area NDA, specifically, the pad area PA within the non-display area NDA, may be an area to which an end of the connection circuit board FB is coupled. The plurality of panel pads PP may be disposed in the pad area PA for electrical connection to the connection circuit board FB. The display panel DP may be electrically coupled to external components such as the connection circuit board FB and the main circuit board MB through the pad area PA.

A driving unit that generates and/or processes various signals for driving the display panel DP may be located in the non-display area NDA. The driving unit may include a data driving unit that applies a data signal to a data line, a gate driving unit that applies a gate signal to a scan line, and a signal control unit that controls the data driving unit and the gate driving unit. A data signal, etc., may be applied to the pixels PX at a selected timing according to a scan signal generated from the gate driving unit.

The connection circuit board FB may be placed in the pad area PA of the display panel DP to connect the main circuit board MB to the display panel DP. The connection circuit board FB may be disposed on a side of the display panel DP extending in the second direction DR2.

The connection circuit board FB may be provided as a single component and is not necessarily limited to any one embodiment. As another example, a plurality of connection circuit boards FB may be provided and may be spaced apart from each other in the first direction DR1 in the pad area PA.

When there are a plurality of connection circuit boards FB, the panel pads PP may be disposed in the pad area PA to correspond to the connection pads FP of the connection circuit board FB.

The connection circuit board FB may be flexible. As a result, the connection circuit board FB connected to the display panel DP may be bent, causing other components, such as the main circuit board MB, connected to the connection circuit board FB, to be placed on the back surface of the display panel DP.

A plurality of connection pads FP may be disposed on the connection circuit board FB for electrical connection to the display panel DP. The connection circuit board FB may be electrically connected to the display panel DP by overlapping the panel pad PP located in the pad area PA of the display panel DP through the connection pad FP. The connection circuit board FB may correspond to the pad area PA to transmit various electrical signals to the display area DA through the panel pad (PP).

The main circuit board MB may be connected to the connection circuit board FB, and may be connected to an end of the connection circuit board FB connected to the display panel DP on the connection circuit board FB and the other end of the connection circuit board FB on the opposite side.

The main circuit board MB may provide image data, a control signal, a power voltage, etc., to the display panel DP. The main circuit board MB may be a wiring board distinct from the connection circuit board FB and may include an active element and a passive element. The main circuit board MB may be flexible or rigid and is not necessarily limited to either embodiment.

A processor and/or a memory, etc., may be positioned on the main circuit board MB. For example, when the display device 1 is applied to a mobile communication terminal, the processor may be an application processor including a central processing unit, a graphic processing unit, and/or a modem, etc. The connection circuit board FB may be bent such that the main circuit board MB may be positioned on the back surface of the display panel DP with respect to a third direction DR3.

Display devices are evolving to reduce a non-display area to make a bezel narrower and to accommodate many parts, such as lines, in a non-display area to operate various functions thereof. To this end, a method may be considered to reduce an area in which panel pads are placed in the pad area, which is a part of the non-display area.

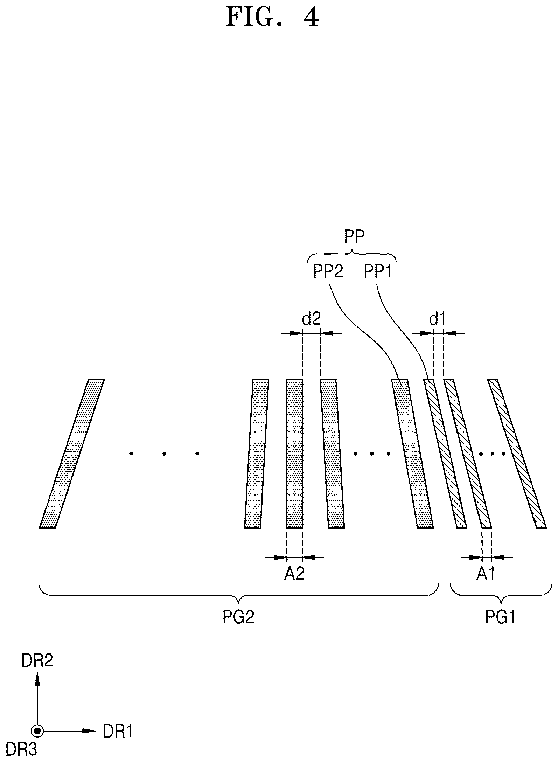

FIG. 4 is a plan view schematically showing a pad region of FIG. 1 according to an embodiment.

The plurality of panel pads PP may be arranged in the first direction DR1 in the pad area PA on the substrate BSL. A plurality of panel pad groups, each including the plurality of panel pads PP, may be disposed in the pad area PA.

A panel pad group may include the plurality of panel pads PP that receive one or more signals to be transmitted to the display area DA. The panel pads PP may be spaced apart from each other.

The panel pad PP may be in the form of extending in the pad area PA, for example, between the edge of the display panel DP and the display area DA. At least two panel pads PP among the plurality of panel pads PP may be inclined without being parallel to each other. For example, the panel pads PP may have different inclinations with respect to the second direction.

A distance between one panel pad PP and the nearest other panel pad PP may be such that a distance between the panel pads PP in the display area DA is less than a distance between the panel pads PP on the edge of the display panel DP. For example, the distances may gradually increase in a direction away from the display area DA. The distance between one panel pad PP and the nearest other panel pad PP may have such a distance that no short circuit occurs at least between adjacent panel pads PP.

The panel pad PP may have various shapes. The panel pad PP may be, for example, in the shape of a quadrilateral, for example, a rectangle, a trapezoid, a parallelogram, etc.

For example, some of the panel pads PP may have the same shape as each other. As another example, some of the panel pads PP may have the same length but different inclinations. As another example, some of the panel pads PP may have the same length but different widths.

In a way to reduce the area of the pad area PA, when a distance from a side of one panel pad PP to a side of another panel pad PP that is most adjacent to the panel pad is called a pitch, a method of reducing the pitch may be devised.

For example, when the pitches between the panel pads PP within a panel pad group are all the same, the pitch between the panel pads PP of the specific panel pad group may be reduced. For example, the distance between the panel pads PP of the specific panel pad group and/or the width of the panel pads PP of the specific panel pad group may be reduced to reduce the area of the pad area PA.

When the pitch between the panel pads PP of the specific panel pad group is reduced at a certain rate, the distance between the panel pads PP of the specific panel pad group and the width of the panel pads PP of the specific panel pad group may be reduced at the same rate.

In the pad area PA, for example, a first panel pad group PG1 and a second panel pad group PG2 arranged in the first direction DR1 may be disposed. The first panel pad group PG1 and the second panel pad group PG2 may each include the panel pads PP.

The first panel pad group PG1 may include first panel pads PP1 having a constant distance from each other, and the second panel pad group PG2 may include second panel pads PP2 having a constant distance from each other. A first distance d1, which is a distance between the first panel pads PP1, may be different from a second distance d2, which is the gap between the second panel pads PP2. For example, the first distance d1 may be less than the second distance d2.

The first panel pads PP1 may have a constant width with respect to each other, i.e. may each have the same width, and the second panel pads PP2 may have a constant width with respect to each other, i.e. may each have the same width. However, a first width A1, which is a width of the first panel pad PP1, may be different from a second width A2, which is a width of the second panel pad PP2. For example, the first width A1 may be less than the second width A2.

For example, a pitch between (of) the first panel pads PP1 included in the first panel pad group PG1 may be less than a pitch between (of) the second panel pads PP2 included in the second panel pad group PG2.

Each panel pad PP may be connected to a line for a specific purpose to drive a specific function. The lines connected to the panel pads PP may include a power line for supplying power to the display device 1, a signal line for transmitting information to the pixels PX, a touch line for detecting a touch input, a backlight line for controlling the backlight, a ground line for providing a common reference voltage, a test line for testing and diagnosing in a manufacturing process of the display device 1, etc.

Among various functions for different purposes, there may be functions that do not require relatively small resistance (e.g., they may be able to function properly at higher resistances). As low resistance is not required, connection to the panel pad PP having a reduced pitch may be possible and thus no problem may occur in spite of a relative increase in the resistance due to a reduction in the width of the panel pad PP.

For example, the function not requiring low resistance may be driven by connecting a line to a panel pad group including the panel pads PP having a narrow distance and a small width. For example, power-related functions may require relatively low resistance, while touch-related functions might not require relatively low resistance. Accordingly, the touch line may be electrically connected to the panel pads PP with a reduced distance between the panel pads PP and/or a reduced width of the panel pads PP compared to the power line.

For example, the touch line may be electrically connected to the first panel pads PP1 included in the first panel pad group PG1 having a pitch less than the pitch between the second panel pads PP2 included in the second panel pad group PG2.

At least two panel pads PP among the plurality of panel pads PP may be disposed in the pad area PA so as to be inclined without being parallel to each other. At this time, upper ends of the panel pads PP in the second direction DR2 perpendicular to the first direction DR1 may be positioned colinearly in the first direction DR1. Each panel pad PP may have a different degree of inclination in the second direction DR2, but opposite terminals of the panel pads PP may be positioned colinearly in the first direction DR1.

The first panel pad group PG1 and the second panel pad group PG2 may each have a width in the first direction DR1, and the width may differ from area to area. For example, one end near the display areas DA of the first panel pad group PG1 and the second panel pad group PG2 may have a less width than the other end near the edges of the display panels DP of the first panel pad group PG1 and the second panel pad group PG2. For example, the widths of the first panel pad group PG1 and the second panel pad group PG2 may gradually increase in a direction away from the display area DA.

Keys may further be included between the panel pad groups to determine whether the panel pads PP are properly placed, properly connected to the connection pads FP of the connection circuit board FB, or properly connected to an integrated circuit (IC). The keys may be positioned between the edge of the pad area PA and the outermost panel pad PP.

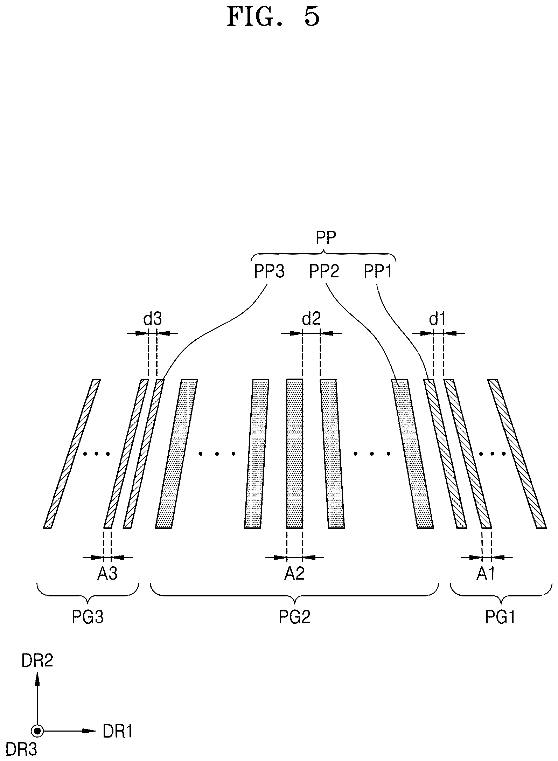

FIG. 5 is a plan view schematically showing a pad region of FIG. 1 according to another embodiment.

The plurality of panel pads PP may be arranged in the first direction DR1 in the pad area PA on the substrate BSL. A plurality of panel pad groups, each including the plurality of panel pads PP, may be disposed in the pad area PA.

In the pad area PA, for example, the first panel pad group PG1, the second panel pad group PG2, and a third panel group PG3, arranged in the first direction DR1, may be disposed. The first panel pad group PG1, the second panel pad group PG2, and the third panel group PG3 may each include the panel pads PP. In the pad area PA, the first panel pad group PG1, the second panel pad group PG2, and the third panel group PG3 may be sequentially arranged in the first direction DR1.

The first panel pad group PG1 may include the first panel pads PP1 that are spaced at a constant distance from each other, the second panel pad group PG2 may include the second panel pads PP2 that are spaced at a constant distance from each other, and the third panel pad group PG3 may include third panel pads PP3 that are spaced at a constant distance from each other.

The first distance d1, which is a distance between the first panel pads PP1, may be different from the second distance d2, which is the gap between the second panel pads PP2. A third distance d3, which is a distance between the third panel pads PP3, may be different from the first distance d1 and/or the second distance d2. For example, the first distance d1 and the third distance d3 may be less than the second distance d2. The first distance d1 and the third distance d3 may be the same as or different from each other.

The first panel pads PP1 may have a constant width with respect to each other, the second panel pads PP2 may have a constant width with respect to each other, and the third panel pads PP3 may have a constant width with respect to each other.

However, the first width A1, which is a width of the first panel pad PP1, may be different from the second width A2, which is a width of the second panel pad PP2. The third width d3, which is a width of the third panel pad PP3, may be different from the first width A1 and/or the second width A2. For example, the first width A1 and the third width A3 may be less than the second width A2. The first width A1 and the third width A3 may be the same as or different from each other.

For example, the pitch between the first panel pads PP1 included in the first panel pad group PG1 and the pitch between the third panel pads PP3 included in the third panel pad group PG3 may be less than the pitch between the second panel pads PP2 included in the second panel pad group PG2.

Each panel pad PP may be connected to a line for a specific purpose to drive a specific function. The lines connected to the panel pads PP may include a power line for supplying power to the display device 1, a signal line for transmitting information to the pixels PX, a touch line for detecting a touch input, a backlight line for controlling the backlight, a ground line for providing a common reference voltage, a test line for testing and diagnosing in a manufacturing process of the display device 1, etc.

With respect to each other, the line not requiring low resistance may be connected to a panel pad group including the panel pads PP having a narrow distance and a small width. For example, the panel pad PP to which a touch line is connected may have a less distance between the panel pads PP and/or a less width of the panel pad PP than the panel pad PP to which the power line is connected.

For example, the touch line may be electrically connected to the first panel pads PP1 included in the first panel pad group PG1 and the third panel pads PP3 included in the third panel pad group PG3, which have a pitch less than the pitch between the second panel pads PP2 included in the second panel pad group PG2.

At least two panel pads PP among the plurality of panel pads PP may be disposed in the pad area PA so as to be inclined without being parallel to each other. For example, the upper ends of the panel pads PP in the second direction DR2 perpendicular to the first direction DR1 may be positioned colinearly in the first direction DR1. Each panel pad PP may have a different degree of inclination in the second direction DR2, but opposite terminals of the panel pads PP may be positioned colinearly in the first direction DR1.

The first panel pad group PG1, the second panel pad group PG2, and the third panel pad group PG3 may each have a width in the first direction DR1, and the width may differ from area to area. For example, ends of the first panel pad group PG1, the second panel pad group PG2, and the third panel pad group PG3, which are close to the display area DA, may have a less width than the other ends of the first panel pad group PG1, the second panel pad group PG2, and the third panel pad group PG3, which are close to the edge of the display panel DP. For example, the widths of the first panel pad group PG1, the second panel pad group PG2, and the third panel pad group PG3 may gradually increase in a direction away from the display area DA.

Keys may further be included between the panel pad groups to determine whether the panel pads PP are properly placed, properly connected to the connection pads FP of the connection circuit board FB, or properly connected to an IC. The keys may be positioned between the edge of the pad area PA and the outermost panel pad PP.

The first panel pad PP1 of the first panel pad group PG1 and the third panel pad PP3 of the third panel pad group PG3 are described and illustrated as having less pitches, distances, and widths than the second panel pad PP2 of the second panel pad group PG2, but they are examples and the present disclosure is not necessarily limited thereto.

For example, as another example, the second panel pad PP2 of the second panel pad group PG2 is described and illustrated as having less pitches, distances, and widths than the first panel pad PP1 of the first panel pad group PG1 and the third panel pad PP3 of the third panel pad group PG3, such that various designs may be possible.

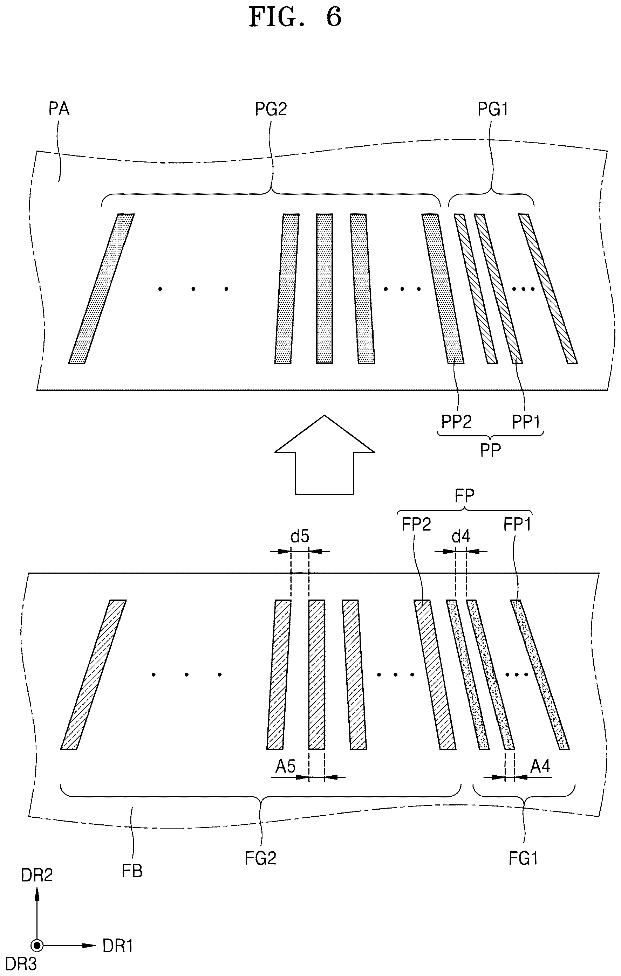

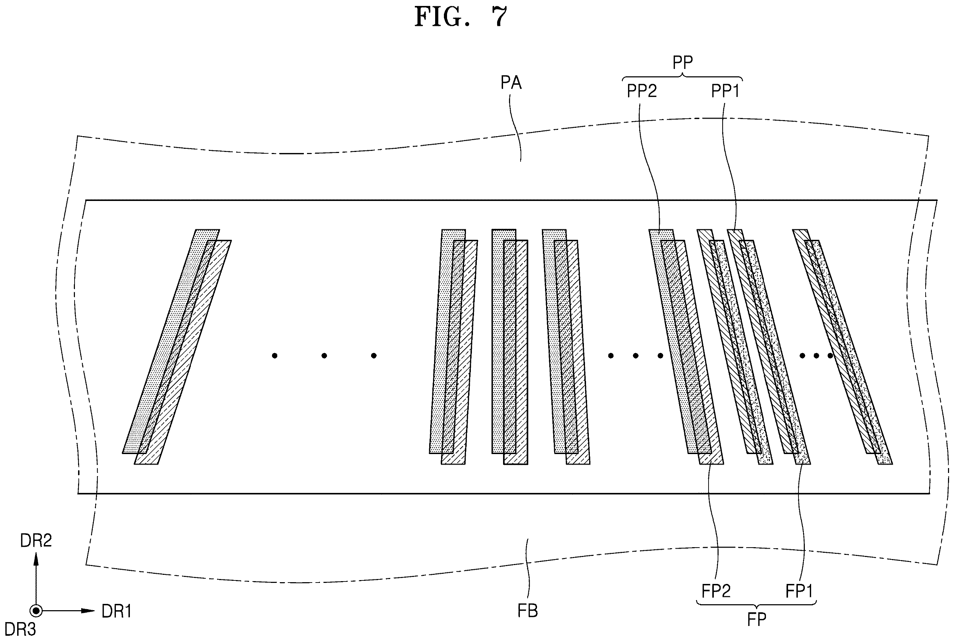

FIG. 6 is a plan view schematically showing a part of a display device separated from a portion A of FIG. 1, and FIG. 7 is a plan view schematically showing a display device in a portion A of FIG. 1.

Each panel pad PP may be electrically connected to each connection pad FP of a corresponding connection circuit board FB to receive signals. The panel pad PP may transmit signals received from the connection circuit board FB to the pixel PX etc., through a line. For example, a plurality of lines may extend from the display area DA and be connected to each of the plurality of panel pads PP. The panel pad PP may electrically connect the connection circuit board FB to the panel pad PP.

The display device 1 may further include the connection circuit board FB having the plurality of connection pads FP arranged in the first direction DR1. On the connection circuit board FB, a first connection pad group FG1 and a second connection pad group FG2 arranged in the first direction DR1 may be disposed.

The first connection pad group FG1 may include first connection pads FP1 having a constant distance from each other, and the second connection pad group FG2 may include second connection pads FP2 having a constant distance from each other.

For example, the first panel pad group PG1 and the second panel pad group PG2, each including the panel pads PP, may be disposed in the pad area PA of the display panel DP. Each of the first panel pad group PG1 and the second panel pad group PG2 may be electrically connected to the corresponding connection pad groups, i.e., a first connection pad group FG1 and a second connection pad group FG2. For example, the first connection pad group FG1 may be electrically connected to the first panel pad group PG1, and the second connection pad group FG2 may be electrically connected to the second panel pad group PG2. This allows the display panel DP and the connection circuit board FB to be electrically connected to each other.

The connection circuit board FB may include the first connection pad group FG1 and the second connection pad group FG2 on a surface of the connection circuit board FB. The shapes of the first connection pad group FG1 and the second connection pad group FG2 may correspond to the shapes of the first panel pad group PG1 and the second panel pad group PG2.

The first connection pad group FG1 and the second connection pad group FG2 may have a width in the first direction DR1, and the widths of the first connection pad group FG1 and the second connection pad group FG2 may differ from area to area. For example, the widths of the first connection pad group FG1 and the second connection pad group FG2 that are close to the display panel DP may be less than the widths of the first connection pad group FG1 and the second connection pad group FG2 that are close to the main circuit board MB, and for example, the widths of the first connection pad group FG1 and the second connection pad group FG2 may gradually decrease toward the edge of the connection circuit board FB close to the display panel DP.

The first connection pad group FG1 and the second connection pad group FG2 may each include the plurality of connection pads FP arranged in the first direction DR1. The connection pad FP may be a path for transmitting a signal from the connection circuit board FB to the display panel DP.

The first connection pad group FG1 and the second connection pad group FG2 respectively correspond to the first panel pad group PG1 and the second panel pad group PG2, and each connection pad FP may correspond to each panel pad PP. For example, one panel pad PP may be connected to one connection pad FP, and might not be connected overlappingly with another panel pad PP.

Each of the connection pads FP may overlap the panel pad PP in at least a region thereof. In some embodiments, a first connection pad FP1, which is the connection pad FP of the first connection pad group FG1, may be electrically connected to the first panel pad PP1 of the first panel pad group PG1 overlappingly with the first panel pad PP1 in at least a region thereof, and a second connection pad FP2, which is the connection pad FP of the second connection pad group FG2, may be electrically connected to the second panel pad PP2 of the second panel pad group PG2 overlappingly with the second panel pad PP2 in at least a region thereof.

As one connection pad FP needs to correspond to one panel pad PP, the connection pads FP may be spaced apart from each other, like the panel pads PP. The connection pad FP may extend in the second direction DR2. At least two connection pads PP among the plurality of connection pads FP may be inclined without being parallel to each other. For example, the connection pads FP may have different inclinations with respect to the second direction DR2.

The connection pads FP may have various shapes. The connection pad FP may be, for example, in the shape of a quadrilateral, for example, a rectangle, a trapezoid, a parallelogram, etc.

At least two connection pads FP among the plurality of connection pads FP may be disposed on the connection circuit board FB so as to be inclined without being parallel to each other. For example, the upper ends of the connection pads FP in the second direction DR2 perpendicular to the first direction DR1 may be positioned colinearly in the first direction DR1. Each connection pad FP may have a different degree of inclination in the second direction DR2, but opposite terminals of the connection pads FP may be positioned colinearly in the first direction DR1.

The connection pad FP may transmit various signals generated in the display device 1 from the connection circuit board FB to the display panel DP through the panel pad PP. For example, a signal generated on the main circuit board MB may be transmitted to the connection circuit board FB through a signal line, and then transmitted to the display panel DP through the panel pad PP via the connection pad FP. The connection pad FP may electrically connect the connection circuit board FB to the panel pad PP.

Each of the plurality of connection pads FP may overlap the corresponding panel pad PP in at least a region thereof. Each of the plurality of connection pads FP of a connection pad group may be electrically connected to each of the plurality of panel pads PP of a corresponding panel pad group.

A fourth distance d4, which is a distance between the first connection pads FP1 belonging to the first connection pad group FG1, may correspond to the first distance d1, which is a distance between the first panel pads PP1 belonging to the first panel pad group PG1. The fourth distance d4 may be equal to the first distance d1, or may have a difference at least enough to allow a one-to-one correspondence between the first connection pads FP1 and the first panel pads PP1.

A fifth distance d5, which is a distance between the second connection pads FP2 belonging to the second connection pad group FG2, may correspond to the second distance d2, which is a distance between the second panel pads PP2 belonging to the second panel pad group PG2. The fifth distance d5 may be equal to the second distance d2, or may have a difference at least enough to allow a one-to-one correspondence between the second connection pads FP2 and the second panel pads PP2.

As the first distance d1 between the first panel pads PP1 and the second distance d2 between the second panel pads PP2 are different from each other, the fourth distance d4 corresponding to the first distance d1 may be different from a fifth distance d5 corresponding to the second distance d2.

The first panel pads PP1 belonging to the first panel pad group PG1 may all have the same distance as one another, and correspondingly, the distance between the first connection pads FP1 belonging to the first connection pad group FG1 may also have the same distance as one another.

The second panel pads PP2 belonging to the second panel pad group PG2 may all have the same distance as one another, and correspondingly, the second connection pads FP2 belonging to the second connection pad group FG2 may also have the same distance as one another.

A fourth width A4, which is a width of the first connection pad FP1 belonging to the first connection pad group FG1, may correspond to the first width A1, which is a width of the first panel pad PP1 belonging to the first panel pad group PG1. The fourth width A4 may be equal to the first width A1, or may have a difference at least enough to allow a one-to-one correspondence between the first connection pads FP1 and the first panel pads PP1.

A fifth width A5, which is a width of the second connection pad FP2 belonging to the second connection pad group FG2, may correspond to the second width A2, which is a width of the second panel pad PP2 belonging to the second panel pad group PG2. The fourth width A5 may be equal to the second width A2, or may have a difference at least enough to allow a one-to-one correspondence between the second connection pads FP2 and the second panel pads PP2.

As the first width A1, which is the width of the first panel pads PP1, is different from the second width A2, which is the width of the second panel pads PP2, the fourth width A4 corresponding to the first width A1 may be different from the fifth width A5 corresponding to the second width A2.

The first panel pads PP1 belonging to the first panel pad group PG1 may all have the same width as one another, and correspondingly, the first connection pads FP1 belonging to the first connection pad group FG1 may also have the same width as one another.

The second panel pads PP2 belonging to the second panel pad group PG2 may all have the same width as one another, and correspondingly, the second connection pads FP2 belonging to the second connection pad group FG2 may also have the same width as one another.

The first connection pad group FG1 may correspond to the first panel pad group PG1. The first connection pads FP1 of the first connection pad group FG1 may respectively overlap the first panel pads PP1 of the first panel pad group PG1.

The width of the first connection pad group FG1 may be the same as the width of the first panel pad group PG1. The first connection pad group FG1 and the first panel pad group PG1 might not need to overlap to match precisely, and may need to overlap such that the first connection pad FP1 and the first panel pad PP1 are connected one-to-one, and thus the first connection pad group FG1 may be slightly misaligned in any direction among up, down, left, or right from the position of the first panel pad group PG1 to the extent that the respective identical pads PP and FP do not have short-circuits.

The second connection pad group FG2 may correspond to the second panel pad group PG2. The second connection pads FP2 of the second connection pad group FG2 may respectively overlap the second panel pads PP2 of the second panel pad group PG2.

The width and length of the second connection pad FP2 may be the same as the width and length of the second panel pad PP2, or may be different such that one second panel pad PP2 overlaps one second connection pad FP2.

When one panel pad PP overlaps one connection pad FP, the center of the panel pad PP may coincide with the center of the connection pad FP. When the centers of the panel pad PP and the connection pad FP do not coincide with each other, a distance of the panel pad PP to the most adjacent panel pad PP without overlapping the connection pad FP may be a distance in which a short-circuit does not occur between the connection pad FP and the panel pad PP. For example, the distance the connection pad FP and the panel pad PP without causing a short-circuit may be at least 35 µm.

Depending on a pitch, which is a distance from a side of one panel pad PP to a side of another panel pad PP that is most adjacent to the panel pad (PP), or equipment process conditions, an optimal overlapping area between the panel pad PP and the connection pad FP and the distance between the connection pad FP and the adjacent panel pad PP may vary, and accordingly, a ratio of the width of the panel pad PP and the distance between the panel pads PP may be adjusted.

For example, when the pitch is 100 µm, the ratio of the width of the panel pad PP and the distance between the panel pads PP may be 60:40. As another example, when the pitch is 70 µm, the ratio of the width of the panel pad PP and the distance between the panel pads PP may be 35:40 or 40:35. However, the present disclosure is not necessarily limited to the foregoing example, and the ratio of the width of the panel pad PP and the distance between the panel pads PP may be adjusted by considering the optimal overlapping area between the panel pad PP and the connection pad FP and the distance between the connection pad FP and the adjacent panel pad PP.

Although it is illustrated and described in FIG. 7 that the first panel pad group PG1 and the second panel pad group PG2 are disposed in the pad area PA and are connected to the first connection pad group FG1 and the second connection pad group FG2 of the connection circuit board FB, this is merely an example, and the third panel pad group PG3 may be further disposed in the pad area PA, and accordingly, the third connection pad group (FG3) of the connection circuit board FB may be formed to correspond and be electrically connected.

Referring to FIG. 7, the display panel DP and the connection circuit board FB may be electrically connected to each other as the panel pad PP of the display panel DP and the connection pad FP of the connection circuit board FB overlappingly contact each other. Hereinbelow, a scheme to connect the panel pad PP to the connection pad FP will be described in detail.

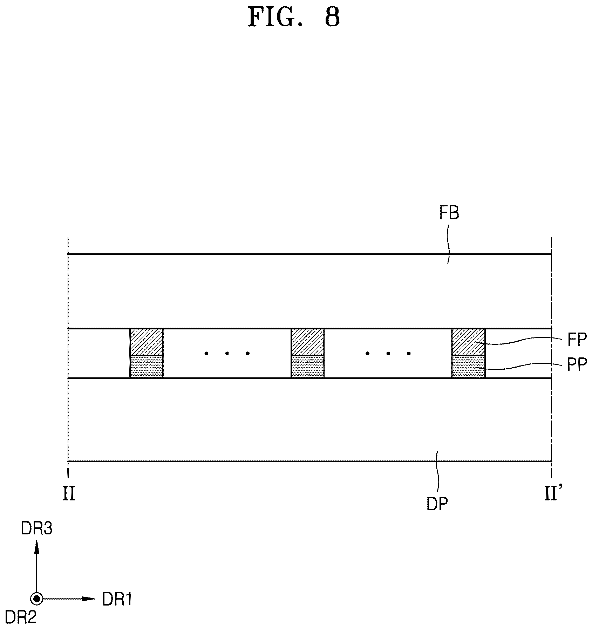

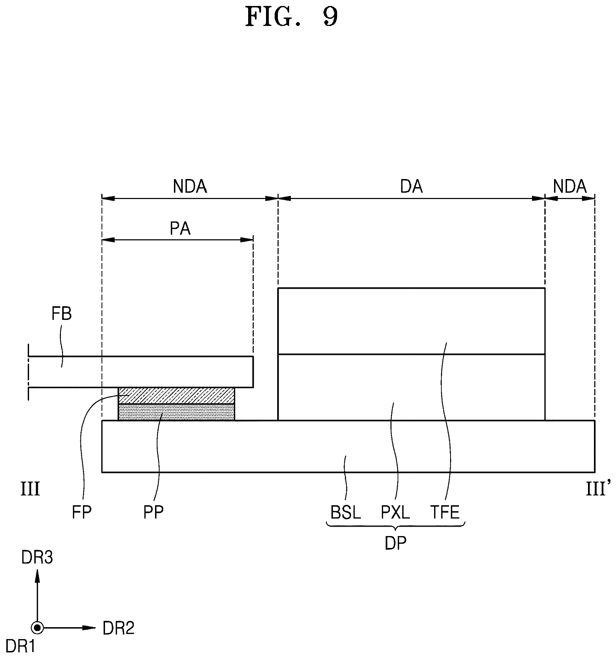

FIG. 8 is a cross-sectional view schematically showing a cross-section taken along line II-II' of FIG. 1, and FIG. 9 is a cross-sectional view schematically showing a cross-section taken along line III-III' of FIG. 1.

Each of the plurality of panel pads PP disposed in the non-display area NDA of the display panel DP may overlap the connection pad FP disposed on a surface of the connection circuit board FB, thereby electrically connecting the connection circuit board FB to the display panel DP.

For example, referring to FIG. 8, the widths of the panel pad PP and the connection pad FP that are electrically connected to each other to overlap each other are the same as each other, and the width of the panel pad PP and the width of the connection pad FP may be connected to each other while corresponding to each other. The width of the panel pad PP and the width of the connection pad FP may be different from each other, and the width of the panel pad PP and the width of the connection pad FP might not correspond to each other, such that opposite side surfaces of the panel pad PP and the connection pad FP might not exactly match each other.

The panel pad PP and the connection pad FP may have an appropriate width to have such structural stability that they are connected to each other to overlap each other and are connected to each other to sufficiently support the connection circuit board FB.

Referring to FIG. 9, the display panel DP may include the display area DA located in the middle of the display panel DP and the non-display area NDA on both sides of the display area DA.

The display panel DP may include the substrate BSL, the pixel layer PXL, and the encapsulation layer TFE laminated in the third direction DR3 on a cross-section.

The substrate BSL may be a base layer on which the pixel layer PXL is formed. The substrate BSL may be a single layer or may include a plurality of insulating layers. The substrate BSL may be at least any one of a glass substrate, a plastic substrate, a film, and a laminate including a plurality of organic films and/or inorganic films, but the present disclosure is not necessarily limited to any one embodiment.

The substrate BSL may include a driving element, a signal line, etc., of the pixel PX. Accordingly, the substrate BSL may have a laminated structure of a plurality of conductive layers and a plurality of organic and/or inorganic films.

The pixel layer PXL may be disposed on the substrate BSL. The pixel layer PXL may be electrically connected to the driving element and signal line of the substrate BSL. The pixel layer PXL may include display elements among the pixels PX described above. For example, when the display panel DP is an organic light-emitting display panel, the pixel layer PXL may include an organic light-emitting layer. The display area DA may correspond to a region where the pixel layer PXL is disposed.

The encapsulation layer TFE may be placed on the pixel layer PXL to cover the pixel layer PXL. The encapsulation layer TFE may protect the pixel layer PXL. The encapsulation layer TFE may cover a side surface of the pixel layer PXL. Depending on the type of display panel DP, the encapsulation layer TFE may be omitted or replaced with another display substrate.

The connection circuit board FB may be placed in the pad area PA of the display panel DP to connect the main circuit board MB to the display panel DP. The connection circuit board FB may be disposed on a side of the display panel DP extending in the second direction DR2.

For example, the connection circuit board FB may be provided as a single component. As another example, the plurality of connection circuit boards FB may be provided and arranged in the first direction DR1 and are not necessarily limited to any one embodiment.

The display device 1 as described above may include panel pad groups including the panel pads PP having different pitches and distances therebetween and different widths. By reducing the pitch and distance between the panel pads PP and the width of the panel pads PP, the area of the pad area PA may also be reduced. The panel pads PP may be further placed in proportion to the area of the reduced pad area PA, and lines, circuits, etc., capable of performing other functions may be further designed, enabling a variety of functional designs.

As the area of the panel pad PP decreases, the area of the corresponding connection circuit board FB may also decrease, thereby providing the effect of reducing costs.

Additional space may be secured according to the reduced pad area PA, and the thickness of the display device 1 may be reduced, allowing various structural designs.

The display device 1 described above may be applied to various products that display images. For example, the display device 1 may be applied to various electronic devices such as mobile phones, tablet and laptop computers, televisions, computer monitors, digital cameras, camcorders, portable game consoles, vehicle displays, head-up displays, wearable displays, augmented reality or virtual reality displays, digital billboards, video walls, etc.

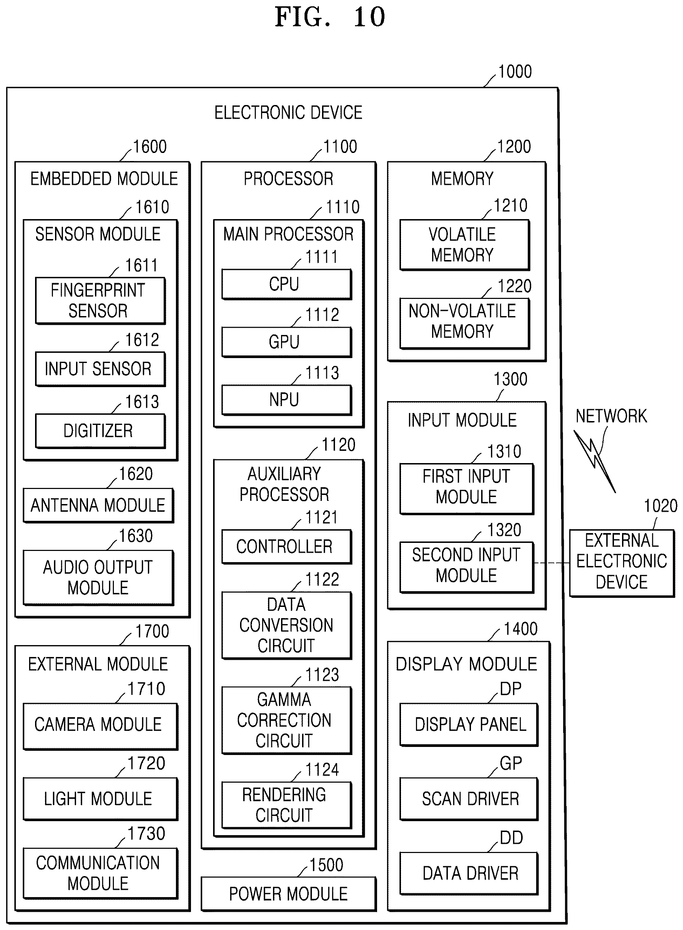

FIG. 10 is a block diagram of an electronic device according to embodiments of the present disclosure. FIG. 10 shows an example, and an electronic device 1000 may selectively include one or more or a plurality of components among a plurality of components shown in FIG. 10 depending on the purpose and design conditions of the electronic device 1000.

The electronic device 1000 may output various information through a display module 1400 within an operating system. The display module 1400 may correspond to the display device 1 of the embodiment or may correspond to at least a partial region thereof.

A touch detection unit or touch electrode of the display module 1400 may be included in a sensor module 1610, and, as described below, the sensor module 1610 may be included in or formed integrally with the display module 1400.

When a processor 1100 executes an application stored in a memory 1200, the display module 1400 may provide application information to the user through the display panel DP.

The processor 1100 may obtain an external input through an input module 1300 or the sensor module 1610 and execute an application corresponding to the external input. For example, when the user selects a camera icon displayed on the display panel DP, the processor 1100 may obtain a user input through an input sensor 1612, for example, a touch detection unit of the aforementioned embodiment, and activate a camera module 1710. The processor 1100 may transmit image data corresponding to a captured image obtained through the camera module 1710 to the display module 1400. The display module 1400 may display an image corresponding to the captured image through the display panel DP.

As another example, when personal information authentication is performed in the display module 1400, a fingerprint sensor 1611 may obtain the input fingerprint information as input data. The processor 1100 may compare the input data obtained through the fingerprint sensor 1611 with authentication data stored in the memory 1200 and execute an application based on a comparison result. The display module 1400 may display information executed according to application's logic through the display panel DP.

As another example, when a music streaming icon displayed on the display module 1400 is selected, the processor 1100 may obtain a user input through the input sensor 1612 and activate the music streaming application stored in the memory 1200. When a music execution command is input in the music streaming application, the processor 1100 may activate an audio output module 1630 to provide the user with audio information corresponding to the music execution command.

So far, the operation of the electronic device 1000 has been briefly described. The configuration of the electronic device 1000 will be described in detail below. Some of the components of the electronic device 1000 described below may be integrated and provided as one component, or one component may be provided separately as two or more components.

Referring to FIG. 10, the electronic device 1000 may communicate with an external electronic device 1020 via a network (e.g., a short-range wireless communication network or a long-range wireless communication network). According to an embodiment, the electronic device 1000 may include the processor 1100 that operates by executing at least one program, the memory 1200 that stores at least one program, the input module 1300, the display module 1400, and a power module 1500 that supplies power to the display module 1400. The processor 1100 may control the input module 1300 to obtain data and may control the display module 1400 to visually display the data.

The electronic device 1000 may further include an embedded module 1600 and an external module 1700. The embedded module 1600 may include a sensor module 1610 that detects an input and generates data corresponding to the input, an antenna module 1620 that transmits or receives data or power to an external electronic device 1002, and an audio output module 1630 that controls the processor 1100 to output data audibly. The external module 1700 may include a camera module 1710 for capturing still images and/or moving images, a light module 1720 for outputting light, and a communication module 1730 for transmitting or receiving data between the electronic device 1000 and the external electronic device 1002.

According to an embodiment, the electronic device 1000 may omit at least one of the components, or may have one or more other components added. According to an embodiment, some of the components described above (e.g., the sensor module 1610, the antenna module 1620, or the audio output module 1630) may be integrated into another component (e.g., the display module 1400).

The processor 1100 may execute software to control at least one other component (e.g., a hardware or software component) of the electronic device 1000 connected to the processor 1100 and may process or compute various data. According to an embodiment, the processor 1100 as at least a part of data processing or operations may store a command or data received from another component (e.g., the input module 1300, the sensor module 1610, or the communication module 1730) in a volatile memory 1210, process the command or data stored in the volatile memory 1210, and store resulting data in a non-volatile memory 1220.

The processor 1100 may include a main processor 1110 and an auxiliary processor 1120. The main processor 1110 may include one or more of a central processing unit (CPU) 1810-1 or an application processor (AP). The main processor 1110 may further include any one or more of a graphic processing unit (GPU) 1112, a communication processor (CP), and an image signal processor (ISP). The main processor 1110 may further include a neural processing unit (NPU) 1113. The NPU (1113) may be a processor specialized in processing an AI model that may be generated through machine learning. The AI model may include a plurality of artificial neural network layers. The artificial neural network may be, but not necessarily limited to, a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof. The AI model may additionally or alternatively include a software structure as well as the hardware structure. At least two of the processing unit and the processor described above may be implemented as a single integrated configuration (e.g., a single chip) or each may be implemented as an independent configuration (e.g., a plurality of chips).

The auxiliary processor 1120 may include a controller 1121. The controller 1121 may include an interface conversion circuit and a timing control circuit. The controller 1121 may receive an image signal from the main processor 1110, convert a data format of the image signal to match interface specifications with the display module 1400, and output the image data. The controller 1121 may output various control signals necessary for driving the display module 1400.

The auxiliary processor 1120 may further include the controller 1121, a data conversion circuit 1122, a gamma correction circuit 1123, a rendering circuit 1124, etc. The data conversion circuit 1122 may receive image data from the controller 1121 and compensate for the image data to display the image at a desired brightness according to the characteristics of the electronic device 1000, the user's settings, etc., or convert the image data to reduce power consumption or compensate for afterimages. The gamma correction circuit 1123 may convert the image data or a gamma reference voltage, etc. such that the image displayed on the electronic device 1000 has desired gamma characteristics. The rendering circuit 1124 may receive the image data from the controller 1121 and render the image data by taking into consideration the pixel layout of the display panel DP applied to the electronic device 1000. At least one of the data conversion circuit 1122, the gamma correction circuit 1123, and the rendering circuit 1124 may be integrated into another component (e.g., the main processor 1110 or the controller 1121). At least one of the data conversion circuit 1122, the gamma correction circuit 1123, and the rendering circuit 1124 may be integrated into a data driver DD described below.

The memory 1200 may store various data used by at least one component of the electronic device 1000 (e.g., the processor 1100 or the sensor module 1610) and input data or output data for commands related thereto. The memory 1200 may include at least one of the volatile memory 1210 and the non-volatile memory 1220.

The input module 1300 may receive commands or data to be used for components of the electronic device 1000 (e.g., the processor 1100, the sensor module 1610, or the audio output module 1630) from an external source of the electronic device 1000 (e.g., the user or the external electronic device 1020).

The input module 1300 may include a first input module 1310 into which a command or data is input from the user and a second input module 1320 into which a command or data is input from the external electronic device 1020. The first input module 1310 may include a microphone, a mouse, a keyboard, a key (e.g., a button), or a pen (e.g., a passive pen or an active pen). The second input module 1320 may support a designated protocol that may be connected wired or wirelessly to the external electronic device 1020. According to an embodiment, the second input module 1320 may include, for example, a high definition multimedia interface (HDMI), a universal serial bus (USB) interface, a secure digital (SD) card interface, or an audio interface. The second input module 1320 may include a connector that may be physically connected to the external electronic device 1020, for example, an HDMI connector, a USB connector, an SD card connector, or an audio connector (e.g., a headphone connector).

The display module 1400 may visually provide information to the user. The display module 1400 may include the display panel DP, a scan driver GP, and the data driver DD.

The display module 1400, the display panel DP, etc. mentioned in FIG. 10 may correspond to a display module DAU or a display panel DPP of the embodiment.

The display panel DP may further include a light-emitting driver. The light-emitting driver may output a light-emitting control signal to the display panel DP in response to the control signal received from the controller 1121. The light-emitting driver may be formed separately from the scan driver GP or may be integrated into the scan driver GP.

The scan driver GP may receive a control signal from the controller 1121 and output a scan signal to the display panel DP in response to the control signal.

The data driver DD may receive the control signal from the controller 1121, convert image data into an analog voltage (e.g., a data voltage) in response to the control signal, and then output the data voltage to the display panel DP.

The data driver DD may be integrated into another component (e.g., the controller 1121). The functions of the interface conversion circuit and the timing control circuit of the controller 1121 may be integrated into the data driver DD.

The display module 1400 may further include a light-emitting driver and a voltage generation circuit. The voltage generation circuit may output various voltages required to drive the display panel DP.

The power module 1500 may supply power to the components of the electronic device 1000. For example, the power module 1500 may generate a first voltage ELVDD and a second voltage ELVSS. The power module 1500 may generate a gate driving voltage (e.g., Gate High Voltage, Gate Low Voltage) required to drive the scan driver GP.

For example, the power module 1500 may mean a power generation unit, a power supply, etc. As a specific example, the power module 1500 may include a battery that performs charging with the power voltage. The battery may include a non-rechargeable primary battery, a rechargeable secondary battery, or a fuel cell.

For example, the power module 1500 may include a power management integrated circuit (PMIC). The PMIC may provide optimized power for each of the modules described above and below.

For example, the power module 1500 may include a wireless power transmission/reception member electrically connected to the battery. The wireless power transmission/reception member may include a plurality of coil-shaped antenna radiators.

The electronic device 1000 may further include the embedded module 1600 and the external module 1700. The embedded module 1600 may include the sensor module 1610, the antenna module 1620, and the audio output module 1630. The external module 1700 may include the camera module 1710, the light module 1720, and the communication module 1730.

The sensor module 1610 may detect an input by the user's body or an input by the pen of the first input module 1310 and generate an electric signal or data value corresponding to the input. The sensor module 1610 may include at least any one of the fingerprint sensor 1611, the input sensor 1612, and a digitizer 1613.

The fingerprint sensor 1611 may generate a data value corresponding to the user's fingerprint. The fingerprint sensor 1611 may include either an optical fingerprint sensor or a capacitive fingerprint sensor.

The input sensor 1612 may generate a data value corresponding to coordinate information of the input by the user's body or the input by the pen. The input sensor 1612 may generate, as the data value, a change in capacitance due to the input. The input sensor 1612 may detect an input from a passive pen or transmit and receive data with an active pen.

The input sensors 1612 may also measure bio-signals such as blood pressure, moisture, or body fat. For example, when the user touches the body part to a sensor layer or a sensing panel and does not move for a certain period of time, the input sensor 1612 may detect a bio signal based on a change in an electric field due to the body part and output the user-desired information to the display module 1400.

The digitizer 1613 may generate a data value corresponding to coordinate information input by the pen. The digitizer 1613 may generate, as a data value, an electromagnetic change due to the input. The digitizer 1613 may detect an input from a passive pen or transmit and receive data with an active pen.

The touch detection unit or touch electrode of the embodiments may be included in the sensor module 1610, and for example, may be included in at least any one of the fingerprint sensor 1611, the input sensor 1612, and the digitizer 1613, and as a specific example, may correspond to the input sensor 1612.

At least one of the fingerprint sensor 1611, the input sensor 1612, and the digitizer 1613 may be implemented as a sensor layer formed on the display panel DP through a continuous process. The fingerprint sensor 1611, the input sensor 1612, and the digitizer 1613 may be disposed on the display panel DP, and one of the fingerprint sensor 1611, the input sensor 1612, and the digitizer 1613, for example, the digitizer 1613, may be disposed under the display panel DP.

As a specific example, as described above, the touch detection unit may be disposed on the display panel DP, and in this case, as a selected embodiment, the touch detection unit may be disposed on the encapsulation layer TFE.

At least two of the fingerprint sensor 1611, the input sensor 1612, and the digitizer 1613 may be formed to be integrated into one sensing panel through the same process. When integrated into one sensing panel, the sensing panel may be disposed on the display panel DP, or as another example, may be placed on a window member placed on the display panel DP, and the position of the sensing panel may be variously determined by controlling the conditions of other manufacturing processes.

As a selected embodiment, at least one of the fingerprint sensor 1611, the input sensor 1612, and the digitizer 1613 may be embedded in the display panel DP. For example, through a process of forming elements (e.g., light-emitting elements, transistors, etc.) included in the display panel DP, at least one of the fingerprint sensor 1611, the input sensor 1612, and the digitizer 1613 may be formed at the same time.

The sensor module 1610 may generate an electrical signal or a data value corresponding to an internal or external state of the electronic device 1000. The sensor module 1610 may further include a gesture sensor, a gyro sensor, a pressure sensor, a magnetic sensor, an acceleration sensor, a grip sensor, a proximity sensor, a color sensor, an IR ray sensor, a vivo sensor, a temperature sensor, a humidity sensor, and/or an illuminance sensor.

The antenna module 1620 may include one or more antennas for transmitting a signal or power to the outside or receiving a signal or power from the outside. According to an embodiment, the communication module 1730 may transmit a signal to an external electronic device or receive a signal from the external electronic device through an antenna suitable for a communication scheme. An antenna pattern of the antenna module 1620 may be integrated into one component of the display module 1400 (e.g., the display panel DP) or the input sensor 1612.

The audio output module 1630 may be a device for outputting an audio signal to the outside of the electronic device 1000, and may include, for example, a speaker used for general purposes such as multimedia playback or recording playback, and a receiver used exclusively for phone reception. According to an embodiment, the receiver may be implemented separately from or as a part of the speaker. The audio output pattern of the audio output module 1630 may be integrated into the display module 1400.

The camera module 1710 may capture a still image and a moving image. According to an embodiment, the camera module 1710 may include one or more lenses, image sensors, or image signal processors. The camera module 1710 may further include an infrared camera capable of measuring the presence or absence, the position, or line of sight of the user, etc.

The light module 1720 may provide light. The light module 1720 may include a light-emitting diode or a xenon lamp. The light module 1720 may operate in conjunction with or independently of the camera module 1710.

The communication module 1730 may support the establishment of a wired or wireless communication channel between the electronic device 1000 and the external electronic device 1020, and the performance of communication through the established communication channel. The communication module 1730 may include any one or all of a wireless communication module (e.g., a cellular communication module, a short-range wireless communication module, a global navigation satellite system (GNSS) communication module) and a wired communication module (e.g., a local area network (LAN) communication module or a power line communication module). The communication module 1730 may communicate with the external electronic device 1020 via a short-range communication network such as Bluetooth, WiFi direct, or infrared data association (IrDA), or a long-range communication network such as a cellular network, the Internet, or a computer network (e.g., a LAN or WAN). Various types of communication module 1730 described above may be implemented as one chip or as separate chips.

The input module 1300, the sensor module 1610, the camera module 1710, etc., may be used to control the operation of the display module 1400 in conjunction with the processor 1100.

The processor 1100 may output a command or data to the display module 1400, the audio output module 1630, the camera module 1710, or the light module 1720 based on input data received from the input module 1300. For example, the processor 1100 may generate the image data in response to the input data received through the mouse or the active pen and output the image data to the display module 1400, or generate command data in response to the input data and output the image data to the camera module 1710 or the light module 1720. When no input data is received from the input module 1300 for a certain period of time, the processor 1100 may reduce power consumption in the electronic device 1000 by switching the operation mode of the electronic device 1000 to a low-power mode or a sleep mode.

The processor 1100 may output a command or data to the display module 1400, the audio output module 1630, the camera module 1710, or the light module 1720 based on sensing data received from the sensor module 1610. For example, the processor 1100 may compare authentication data applied by the fingerprint sensor 1611 with authentication data stored in the memory 1200 and execute an application based on the comparison result. The processor 1100 may execute a command or output corresponding image data to the display module 1400 based on the sensing data sensed by the input sensor 1612 or the digitizer 1613. When a temperature sensor is included in the sensor module 1610, the processor 1100 may receive temperature data on the temperature measured from the sensor module 1610 and perform brightness correction, etc., on the image data based on the temperature data.

The processor 1100 may receive measurement data on the presence or absence, position, and line or sight of the user, etc., from the camera module 1710. The processor 1100 may further perform brightness correction, etc., on the image data based on the measurement data. For example, the processor 1100 that determines the presence or absence of the user through the input from the camera module 1710 may output the image data with brightness corrected through the data conversion circuit 1122 or the gamma correction circuit 1123 to the display module 1400.

Some of the components may be connected to one another via a communication scheme between peripheral devices (e.g., a bus, general purpose input and output (GPIO), a serial peripheral interface (SPI), a mobile industry processor interface (MIPI), or an ultra-path interconnect (UPI) link) to exchange signals (e.g., a command or data). The processor 1100 may communicate with the display module 1400 through a mutually agreed interface, and may use, for example, any one of the communication schemes, and is not necessarily limited to the communication schemes.

The electronic device 1000, according to various embodiments disclosed herein, may be devices of various forms. The electronic device 1000 may include, for example, at least one of a portable communication device (e.g., a smartphone), a computer device, a portable multimedia device, a portable medical device, a camera, a wearable device, or a home appliance device. The electronic device 1000, according to an embodiment herein, is not necessarily limited to the devices described above.

The display module included in the electronic device (1000) may include the features of the display panel DP described above in FIGS. 1 to 9. Those of ordinary skill in the art will readily understand that the description of the display panel DP described above in FIGS. 1 to 9 may be applied to the display module of FIG. 10. Each of the embodiments described above may be implemented independently, but it goes without saying that the structure of each embodiment may be applied in combination to other embodiments.

An implementation of the electronic device 1000 will be specifically described.

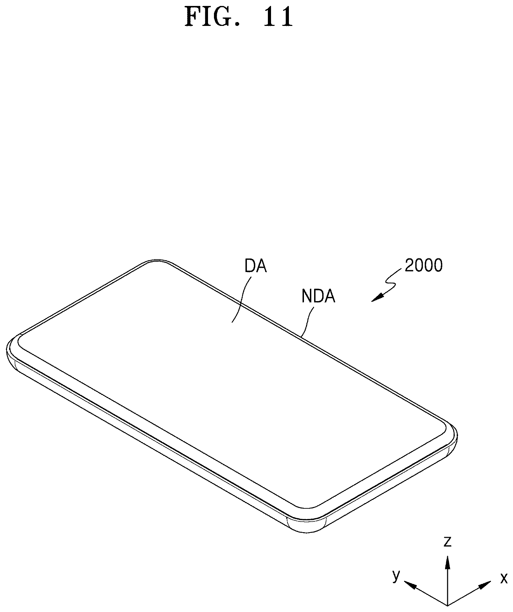

FIG. 11 is a perspective view for describing another electronic device to which a display device according to an embodiment is applied.

The display device 1 may be easily applied to various electronic devices.

For example, the display device ,1 according to the embodiments, may be various products or a part thereof such as not only portable electronic devices including a mobile phone, a smart phone, a tablet computer, a mobile communication terminal, an electronic notebook, an electronic book, a portable multimedia player (PMP), a navigation device, an ultra-mobile PC (UMPC), etc., but also a television, a laptop, a computer monitor, a digital billboard, an Internet of Things (IOT) device, etc.

The display device 1, according to the embodiments, may be a wearable device or a part thereof, such as a smart watch, a watch phone, a glasses-type display, or a head mounted display (HMD).

The present disclosure is not necessarily limited thereto. For example, the display device 1, according to the embodiments described above, may be included in an instrument panel of a vehicle, a center information display (CID) disposed on a center fascia or dashboard of a vehicle, a room mirror display replacing a side mirror of a vehicle, a display disposed on the rear seat entertainment of a vehicle or the back of a front seat, a head-up display (HUD) installed at the front of a vehicle or projected on a front window glass, and a computer-generated hologram augmented reality head-up display (CGH AR HUD).

For example, FIG. 11 shows a case in which an electronic device 2000 to which the display device 1 according to the embodiments is applied is a smartphone.

The electronic device 2000 may include the display area DA and the peripheral area NDA proximate to the display area DA. The display area DA may overlap the display area DA of the display device 1 described above, or as another example, may partially obscure the display area DA. The peripheral area NDA of the electronic device 2000 may be an area where an image is not displayed, and may be an area that entirely or partially overlaps the peripheral area NDA of the display device 1. In the peripheral area NDA of the electronic device 2000, a driver for providing electrical signals or power to display elements disposed in the display area DA may be disposed, and a pad, which is an area to which electronic elements or printed circuit boards may be electrically connected, may also be disposed. The electronic device 2000 that is a smart phone may be of a rigid type, or may include various types, such as a bending type in which one side or opposite sides are bent as another example, or a foldable type in which the electronic device 200 is folded more than once as another example.

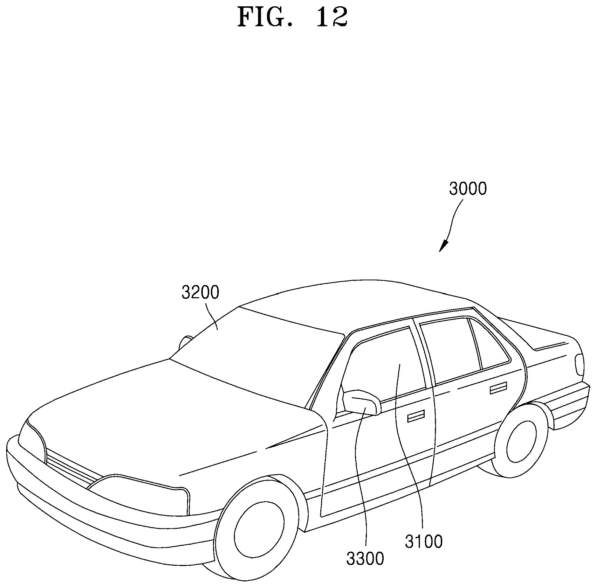

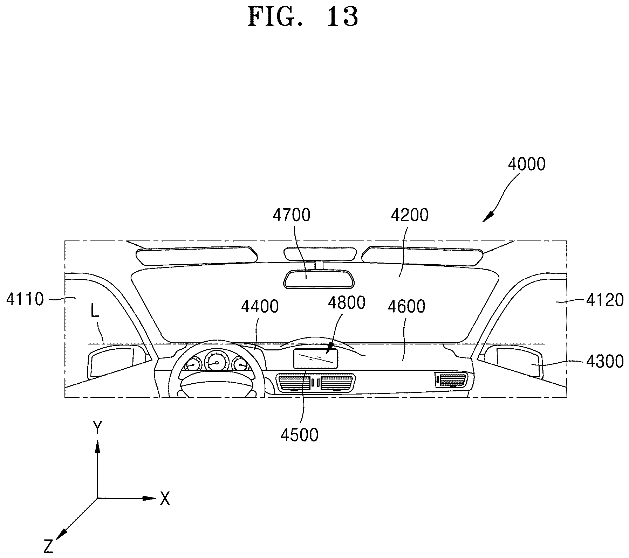

FIGS. 12 and 13 are views for describing another electronic device to which a display device according to an embodiment is applied.

FIG. 12 is a view schematically showing the exterior of a vehicle 3000 to which a display device is applied as a specific example.

The vehicle 3000 may refer to various devices for moving an object to be transported such as a person, cargo, or an animal, and may include a vehicle running on a road or a rail, a ship moving on the sea or a river, and an airplane flying in the sky using the action of the air.

The vehicle 3000 may move in a selected direction according to the rotation of at least one wheel. For example, the vehicle 3000 may include a three-wheeled or four-wheeled vehicle, construction equipment, a two-wheeled vehicle, a motorized device, a bicycle, and a train running on a track.

The vehicle 3000 may include a body having an interior and an exterior, and a chassis on which mechanical devices necessary for driving are installed, as the other part than the body. The exterior of the body may include a front panel, a bonnet, a roof panel, a rear panel, a trunk, and a pillar provided on a boundary between doors.

The chassis of the vehicle 3000 may include a power generation device, a power transmission device, a driving device, a steering device, a braking device, a suspension device, a transmission device, a fuel device, front, rear, left, and right wheels, etc.

The vehicle 3000 may include a side window glass 3100, a front window glass 3200, and a side mirror 3300.

The display device 1, according to the embodiments, may be applied to a region of the vehicle 3000, for example, any one of the side window glass 3100, the front window glass 3200, and the side mirror 3300. A user, for example, a driver or passenger of the vehicle 3000, may visually check information inside the vehicle 3000 through one of the window glass 3100, the front window glass 3200, and the side mirror 3300. The user may perform a touch operation for input such as to check the desired information, etc., and may detect touch and process information through the touch detection unit. Selectively, drivers, passengers or outside passers-by may also view various information displayed on the vehicle 3000 from outside the vehicle.

FIG. 13 is a view schematically showing the interior of a vehicle 4000 to which a display device is applied as a specific example.

The interior of a vehicle 4000 may include a cluster 4400, a center fascia 4500, and a passenger seat dashboard 4600.

The vehicle 4000 may include side window glasses 4100, and the side window glasses 4100 may include a first side window glass 4110 and a second side window glass 4120.

One or more side mirrors 4300 may be included in the vehicle 4000. The cluster 4400 may be located in front of a steering wheel. The cluster 4400 may be configured with a tachometer, a speedometer, a coolant temperature gauge, a fuel gauge, a turn signal indicator, a high beam lamp, a warning light, a seat belt warning light, a trip meter, an odometer, an automatic transmission selection lever lamp, a door open warning light, an engine oil warning light, and/or a low fuel warning light.

The center fascia 4500 may include a control panel having a plurality of buttons to adjust an audio device, an air conditioning device, and a seat heater. The center fascia 4500 may be disposed on a side of the cluster 4400.

The passenger seat dashboard 4600 may be disposed on a side of the center fascia 4500.

The display device 1, according to the embodiments, may be applied to a region of the vehicle 4000, for example, one or more of the cluster 4400, the center fascia 4500, and the passenger seat dashboard 4600, and also, as another example, to a rear mirror unit 4700. In this way, a user, for example, a driver or passenger of the vehicle 4000, may visually check information through one or more of the cluster 4400, the center fascia 4500, the passenger seat dashboard 4600, and the rear mirror unit 4700 inside the vehicle 4000, perform a touch operation for input such as to check information, etc., and perform touch detection and information processing through the touch detection unit.

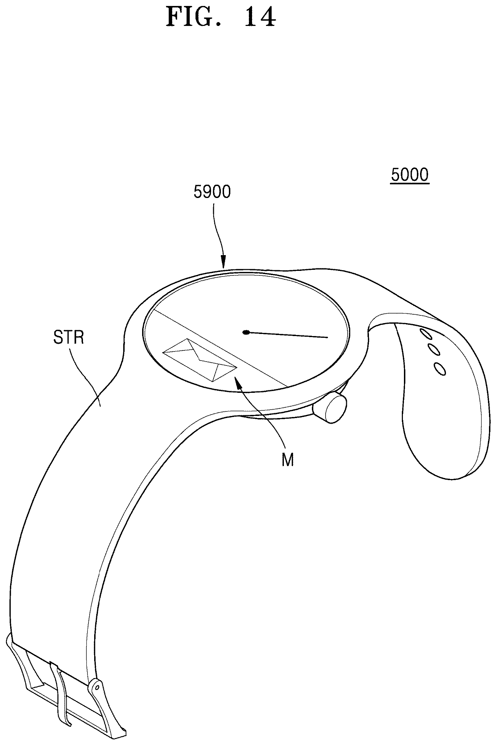

FIG. 14 is a view for describing another electronic device to which a display device according to an embodiment is applied.

The display device 1 may be easily applied to various electronic devices, and may be applied to electronic devices carried or worn by the user, for example, a wearable device.

Referring to FIG. 14, in an example of the present disclosure, the electronic device may be a wearable electronic device 5000, for example, a smart watch.

The wearable electronic device 5000 may include a main body 5900 and a fixing part, such as a strap, STR. The main body 5900 may display an image IM having certain information.

The image IM may be implemented through the aforementioned display device 1 and may be implemented as light emitted from one or more light-emitting regions. An area where the image IM is displayed may include a region where a user's touch is detected, i.e., a region where the touch detection unit having touch electrodes is disposed. In this way, the user may check the image IM of the main body 5900 while wearing or carrying the wearable electronic device 5000 or perform an input operation through a user's direct touch or a user's touch by a touch pen. In other words, the main body 5900 may include the display device 1 described above.

The IM may display an image such as a conventional analog clock, such as a clock hand indicating the current time, as well as an icon or an execution screen of an application running on an application processor.

The main body 5900 may be detachably coupled to the fixing part STR. The user may wear the fixing part STR on his/her wrist to use the wearable electronic device 5000. The fixing part STR may be in the form of a strap, but the fixing part STR is not necessarily limited to a purpose for being worn on the user's wrist. The fixing part STR may be of a type for wearing on the user's arm or around the neck, or may be replaced with a cradle for mounting the main body 5900 to another electronic device.

According to an embodiment, by adjusting a distance between panel pads of a display panel and connection pads of a connection circuit board to reduce areas of a pad area of the display panel and the connection circuit board, a display device and an electronic device including the same may be implemented with improved design flexibility.

However, the scope of the present disclosure is not necessarily limited by these effects.

Although the present disclosure has been described with reference to an example shown in the drawings, it will be understood by those of ordinary skill in the art that various modifications and equivalent other examples may be made from the shown example. Accordingly, the true technical scope of the present disclosure should be defined by the claims.

Specific implementations described in the embodiments are examples and do not necessarily limit the scope of the embodiments in any way.

In the specification of the present disclosure, the use of the term "the" and similar indicators thereof may correspond to both the singular and the plural. In addition, when the range is described in the embodiments, the range includes the present disclosure to which an individual value falling within the range is applied (unless stated otherwise), and is the same as the description of an individual value constituting the range in the description of the present disclosure. Finally, when there is no apparent description of the order of operations constituting the method according to the present disclosure or a contrary description thereof, the operations may be performed in an appropriate order. However, the embodiments are not necessarily limited according to the describing order of the operations. The use of all examples or exemplary terms in the present disclosure are to simply describe the present disclosure in detail, and unless the range of the present disclosure is not necessarily limited by the examples or the exemplary terms. In addition, it may be understood by those of ordinary skill in the art that various modifications, combinations, and changes may be made according to design conditions and factors within the scope of the present disclosure.

## Claims

1. A display device, comprising:
a substrate comprising a display area and a non-display area proximate to the display area;
a thin-film transistor disposed on the substrate; and
a light-emitting element disposed within the display area on the substrate and electrically connected to the thin-film transistor,
wherein the non-display area comprises a pad area in which a plurality of panel pads arranged in a first direction are disposed,
wherein a first panel pad group and a second panel pad group arranged in the first direction are disposed in the pad area,
wherein the first panel pad group comprises first panel pads having a first predetermined distance between adjacent first panel pads,
wherein the second panel pad group comprises second panel pads having a second predetermined distance between adjacent second panel pads, and
wherein the first predetermined distance is different from the second predetermined distance.

2. The display device of claim 1, wherein a third panel pad group comprising third panel pads arranged in the first direction and having a third predetermined distance between adjacent third panel pads is further disposed in the pad area,
wherein the third predetermined distance is different from each of the first predetermined distance and the second predetermined distance.

3. The display device of claim 2, wherein the first panel pad group, the second panel pad group, and the third panel pad group are sequentially arranged in the first direction in the pad area.

4. The display device of claim 2 or 3, wherein the first predetermined distance and the third predetermined distance are each less than the second predetermined distance.

5. The display device of claim 4, wherein the first panel pad group and/or the third panel pad group are electrically connected to a touch line.

6. The display device of claim 1, wherein at least two panel pads among the first panel pads and the second panel pads are inclined without being parallel to each other.

7. The display device of any one of the preceding claims, wherein upper ends of the first and second panel pads in a second direction perpendicular to the first direction are disposed colinearly in the first direction.

8. The display device of claim 1, wherein the first panel pad group comprises first panel pads each having a first predetermined width,
wherein the second panel pad group comprises second panel pads each having a second predetermined width, and
wherein the first predetermined width is different from the second predetermined width.

9. The display device of claim 8, wherein a third panel pad group comprising third panel pads arranged in the first direction and each having a third predetermined width is further disposed in the pad area,
wherein the third predetermined width is different from each of the first predetermined width and the second predetermined width.

10. The display device of claim 9, wherein the first panel pad group, the second panel pad group, and the third panel pad group are sequentially arranged in the first direction in the pad area, and/or wherein the first predetermined width and the third predetermined width are each less than the second predetermined width.

11. The display device of any one of claims 8 to 10, wherein the distance between the first panel pads is different from the distance between the second panel pads.

12. The display device of any one of claims 8 to 11, wherein at least two panel pads among the first panel pads and the second panel pads are inclined without being parallel to each other.

13. The display device of any one of claims 8 to 12,
wherein first ends of the first panel pad group and the second panel pad group, which are closest to the display area, are narrower than second ends of the first panel pad group and the second panel pad group, which are closest to an edge of the substrate, and
wherein opposite terminals of the first and second panel pads in a second direction perpendicular to the first direction are disposed colinearly in the first direction.

14. The display device of any one of the preceding claims, further comprising a connection circuit board having a plurality of connection pads arranged in the first direction,
wherein a first connection pad group and a second connection pad group arranged in the first direction are disposed on the connection circuit board,
wherein the first connection pad group comprises first connection pads having a fourth predetermined distance between adjacent first connection pads,
wherein the second connection pad group comprises second connection pads having a fifth predetermined distance between adjacent second connection pads, and
wherein the first connection pads are electrically connected to the first panel pad group, and the second connection pads are electrically connected to the second panel pad group, optionally wherein the fourth predetermined distance is different from the fifth predetermined distance.

15. An electronic device, comprising:
a controller configured to generate a scan input signal;
a power module configured to generate a scan input voltage;
a display device according to any one of the preceding claims.
